# EUROPEAN PATENT APPLICATION

(11) **EP 4 451 059 A1**
(43) Date of publication of application: **23.10.2024**
(21) Application number: 23168665.0
(22) Date of filing: 19.04.2023
(51) Int. Cl.: G03F 7/00, G02B 7/00, G02B 27/62

(54) **USING REINFORCEMENT LEARNING TO DETERMINE OPTIMAL ALIGNMENT FOR AN OPTICAL SYSTEM**

(71) Applicant: ASML Netherlands B.V., 5500 AH Veldhoven (NL)
(72) Inventor: HARRISON, Kramer, Daniel, 5500 AH Veldhoven (NL); TAN, Jeryl, Jing, Xian, 5500 AH Veldhoven (NL); KOCKEROLS, Jean, 5500 AH Veldhoven (NL); PASVEER, Willem, Franke, 5500 AH Veldhoven (NL)
(74) Representative: ASML Netherlands B.V.

(57) **Abstract**

Corrections and/or other adjustments to an optical system of a lithography, metrology, and/or other apparatuses are typically based on information from a prior manufacturing and/or metrology operation, user experience with the lithography and/or metrology system and/or process, basic optical physics principles, and/or other information. Advantageously, the present systems and methods use reinforcement learning to optimize the alignment of tens, hundreds, thousands, or millions of optical system components (along with associated settings and/or other characteristics), and make corrections and/or other adjustments that optimize adjustment and/or processing time, and/or costs.

## Description

### TECHNICAL FIELD

This description relates to using reinforcement learning to determine optimal alignment for an optical system.

### BACKGROUND

Integrated circuit manufacturing may include various processes such as lithography, etching, deposition, chemical mechanical polishing, ion implantation, and/or other operations. Individual operations may yield parts that meet manufacturing specifications, or parts that are rejected for not meeting these specifications. Corrections to a manufacturing operation may be made based on whether a part meets manufacturing specifications, for example.

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish an individual layer of the device. If several layers are required in the device, then the whole procedure, or a variant thereof, is repeated for each layer. Eventually, a device will be present in each target portion on the substrate. These devices are then separated from one another by a technique such as dicing or sawing. Individual devices can be mounted on a carrier, connected to pins, etc.

Manufacturing semiconductor devices typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc. One or more metrology processes are also typically involved in the patterning process.

Lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the number of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, and/or an extreme ultraviolet illumination source, creating individual functional elements having dimensions well below 100 nm, i.e. less than half the wavelength of the radiation from the illumination source.

This process in which features with dimensions smaller than the classical resolution limit of a lithographic projection apparatus are printed, is commonly known as low-k₁ lithography, according to the resolution formula CD = k₁×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and ki is an empirical resolution factor. In general, the smaller ki the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but are not limited to, alignment of the optical system(s) of the lithographic projection apparatus, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET).

### SUMMARY

Corrections and/or other adjustments to an optical system of a lithography, metrology, and/or other apparatuses are typically based on information from a prior manufacturing and/or metrology operation, user experience with the lithography and/or metrology system and/or process, basic optical physics principles, and/or other information. Advantageously, the present systems and methods use reinforcement learning to optimize the alignment of tens, hundreds, thousands, or millions of optical system components (along with associated settings and/or other characteristics), and make corrections and/or other adjustments that optimize adjustment and/or processing time, and/or costs.

According to an embodiment, a method for aligning an optical system is provided. The method comprises determining, with one or more processors, a state of components of the optical system. The state is determined based on input information associated with the components of the optical system. The method comprises determining, with the one or more processors, based on the state of the components, an alignment metric associated with the components of the optical system. The alignment metric comprises an indication of whether alignment requirements for the components of the optical system are satisfied for the state. The method comprises iteratively, with the one or more processors, adjusting the state of the components based on the alignment metric. Iterative adjustments are configured to enhance the alignment metric. Determining the state, determining the alignment metric, and iteratively adjusting the state are performed as at least part of a reinforcement learning framework.

In some embodiments, iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied. Some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.

In some embodiments, determining the state, determining the alignment metric, and iteratively adjusting the state are performed for tens, hundreds, thousands, and/or millions of components of the optical system.

In some embodiments, the reinforcement learning framework comprises a trained neural network with weights of the neural network determined based on adjustments that diminish the alignment metric, and adjustments that enhance the alignment metric.

In some embodiments, the one or more processors comprise an agent of the reinforcement learning framework.

In some embodiments, iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments.

In some embodiments, the method further comprises performing the determining of the state, the determining of the alignment metric, and the iteratively adjusting the state of the components as part of a serving operational phase; and prior to the serving phase, training the policy function and the reward function during a training operational phase. In some embodiments, the training operational phase is performed in a simulated optical system and/or semiconductor manufacturing environment.

In some embodiments, determining the alignment metric comprises calculating the alignment metric, and iteratively adjusting the state of the components comprises recalculating the alignment metric for each adjusted state of the components.

In some embodiments, the optical system comprises an electronic model generated based on a corresponding physical optical system. In some embodiments, the optical system comprises a source and/or an illuminator, a projection optics box, a drive laser, and/or a plasma generator associated with a lithography apparatus.

In some embodiments, the state of the components of the optical system comprises an arrangement of the optical components relative to each other, operating set points for one or more of the components; an indication of plasma alignment; plasma spatial, angular and/or spectral distributions; plasma energy per pulse per spectral band; drive laser alignment, power, beam profile, temporal profile, and/or pulse profile; mirror physical and/or material properties including spectrally-resolved reflectivity/absorption, surface roughness and stray light behavior, and/or polarization behavior; mirror alignment and/or positioning including a collector position and/or orientation, field facet mirror actuations per field facet, and/or pupil facet mirror alignment; gas absorption behavior including gas species, gas densities, gas pressures, and/or gas temperatures - all spatially and/or spectrally-resolved; and/or relationships and/or behavior associated with mirror degradation rates and effects that can impact mirror degradation rates; and/or other information.

In some embodiments, the alignment metric comprises an alignment value, an optical system alignment speed, a semiconductor manufacturing process throughput associated with the optical system, an indication of a tradeoff between alignment speed and process throughput, a power associated with a semiconductor manufacturing process, a yield associated with a semiconductor manufacturing process, and/or other metrics. In some embodiments, the alignment metric comprises a combination of throughput associated with a semiconductor device manufacturing process and optical system alignment speed, and enhancing the alignment metric for individual adjusted states during the iteratively adjusting comprises optimizing both the throughput and the alignment speed in combination such that final alignment requirements for the optical system are satisfied.

In some embodiments, the method further comprises using a sequence of adjustments and/or a pattern of adjustments determined based on the iteratively adjusting the state of the components to align a corresponding physical optical system.

In some embodiments, iteratively adjusting comprises (1) optimizing the alignment metric based on individual states during a sequence of adjustments, and determining adjustments in the sequence of adjustments based on the optimized alignment metric; and/or (2) prompting a user to make the adjustments.

In some embodiments, an adjustment comprises a correction. In some embodiments, an adjustment comprises a change in an arrangement of the optical components relative to each other and/or operating set points for one or more of the components. In some embodiments, each adjustment during the iteratively adjusting is determined based on a set of possible actions in an action space associated with the components of the optical system, and a corresponding set of observations that are observed for the components of the optical system in response to an adjustment of the state. In some embodiments, the set of possible actions is infinite or finite, and the action space is a continuous or discrete space.

In some embodiments, the input information comprises measured, modeled, and/or inferred information about the optical system and/or the components of the optical system.

In some embodiments, the method is performed for a lithography operation in a semiconductor device manufacturing process.

According to another embodiment, a method for aligning tens, hundreds, thousands, or millions of components of an optical system is provided. The optical system comprises an electronic model generated based on a corresponding physical optical system. The method comprises determining, with one or more processors, a state of components of the optical system. The state is determined based on input information associated with the components of the optical system. The method comprises determining, with the one or more processors, based on the state of the components, an alignment metric associated with the components of the optical system. The alignment metric comprises an indication of whether alignment requirements for the components of the optical system are satisfied for the state. The method comprises iteratively, with the one or more processors, adjusting the state of the components based on the alignment metric. The iterative adjustments are configured to enhance the alignment metric. Each adjustment during the iteratively adjusting is determined based on a set of possible actions in an action space associated with the components of the optical system, and a corresponding set of observations that are observed for the components of the optical system in response to an adjustment of the state. The set of possible actions is infinite. The action space is a continuous or discrete space. Determining the state, determining the alignment metric, and iteratively adjusting the state are performed as part of a reinforcement learning framework. The reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.

According to another embodiment, a method for training a reinforcement learning framework to align tens, hundreds, thousands, or millions of components of an optical system is provided. The optical system comprises an electronic model generated based on a corresponding physical optical system. The method is performed by one or more processors configured by machine readable instructions. The method comprises inputting input information associated with the components of the optical system into the reinforcement learning framework. The method comprises determining, with the reinforcement learning framework, based on the state of the components, an alignment metric associated with the components of the optical system. The alignment metric comprises an indication of whether alignment requirements for the components of the optical system are satisfied for the state. The method comprises iteratively, with the reinforcement learning framework, adjusting the state of the components based on the alignment metric. Iterative adjustments are configured to enhance the alignment metric. Each adjustment during the iteratively adjusting is determined based on a set of possible actions in an action space associated with the components of the optical system, and a corresponding set of observations that are observed for the components of the optical system in response to an adjustment of the state. The set of possible actions is infinite or finite. The action space is a continuous or discrete space. The reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.

According to another embodiment, there is provided a method for aligning components of an optical system. The method comprises obtaining an alignment template. The alignment template defines an optimum set of alignment operations, including which adjustments should be made to which optical components in which order for the optical system. The alignment template is previously determined by inputting input information associated with the components of the optical system into a reinforcement learning framework; determining, with the reinforcement learning framework, based on a state of the components, an alignment metric associated with the components of the optical system, the alignment metric comprising an indication of whether alignment requirements for the components of the optical system are satisfied for the state; and iteratively, with the reinforcement learning framework, adjusting the state of the components based on the alignment metric. Iterative adjustments are configured to enhance the alignment metric. Each adjustment during the iteratively adjusting is determined based on a set of possible actions in an action space associated with the components of the optical system, and a corresponding set of observations that are observed for the components of the optical system in response to an adjustment of the state. The reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied. The optimum set of alignment operations, including which adjustments should be made to which optical components in which order for the optical system, are determined based on iterative adjustments that satisfy the final alignment requirements for the optical system. The method comprises using the alignment template to align the components of the optical system.

According to another embodiment, a non-transitory computer readable medium is provided, having machine readable instructions thereon, the instructions when executed by a computer implementing the method of any of the embodiments described above.

According to another embodiment, a system comprising one or more processors and/or other components is provided, the one or more processors configured for implementing the method of any of the embodiments described above.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Fig. 1 shows a block diagram of various subsystems of a lithography system, according to an embodiment.
Fig. 2 illustrates a schematic overview of a lithographic cell, according to an embodiment.
Fig. 3 illustrates a schematic representation of holistic lithography, representing a cooperation between three technologies to optimize semiconductor processing, according to an embodiment.
Fig. 4 illustrates a summary of operations of a present method for using reinforcement learning for aligning an optical system, according to an embodiment.
Fig. 5 illustrates an example of a misaligned optical system that may be aligned using the present systems and methods, according to an embodiment.
Fig. 6 illustrates how a decision-making agent interacts with the other components of a reinforcement learning framework, according to an embodiment.
Fig. 7 is a block diagram of an example computer system, according to an embodiment.
Fig. 8 is a schematic diagram of a lithographic projection apparatus, according to an embodiment.
Fig. 9 is a schematic diagram of another view of the lithographic projection apparatus, according to an embodiment.
Fig. 10 is a more detailed view of the apparatus in Fig. 9, according to an embodiment.
Fig. 11 is a more detailed view of the source collector module SO of the apparatus of Fig. 9 and Fig. 10, according to an embodiment.

### DETAILED DESCRIPTION

Optical systems are typically aligned based on optical physics principles and/or expert knowledge. Physics-based optical models have been used to understand optical system sensitivities and relationships between optical system components, and to identify potential alignment strategies. For optimal performance (e.g., based on throughput, imaging, etc.) of EUV optical systems (e.g. NXE systems), the optimal alignment of tens, hundreds, thousands, or millions of optical system components and associated set points and/or other characteristics (e.g., thousands to millions or more degrees of freedom for an optimization) is required. Further, the optimal alignment depends on many factors that can also change with time, or from optical system to optical system (e.g., machine to machine such as different lithography apparatuses, different metrology apparatuses, etc.). For example, variation in the plasma distribution in a lithography apparatus may impact optimal plasma position, or degradation of illuminator mirrors (e.g. pupil or field facets) may impact optimal field facet tilt positions, some or all of which may form a portion of an optical system as described herein.

In the context of EUV lithography apparatus optical systems (as one representative example), disadvantages of the optical physics principles and/or expert knowledge based alignment approaches include long alignment process durations and suboptimal alignment (sometimes even after a long alignment process duration). As an example, a typical optical system alignment can take hours to complete, which significantly decreases the amount of manufactured chips (in this example) that can be produced. In addition, the optical physics principles and/or expert knowledge based alignment approaches generally do not utilize knowledge of the optical system state, which could improve alignment convergence and/or have other effects. Continuing with the EUV lithography apparatus example, the optical physics principles and/or expert knowledge based alignment approaches generally do not consider a priori knowledge of mirror properties when aligning the plasma, even though these properties can impact alignment.

Advantageously, the present systems and methods use reinforcement learning to optimize the alignment of the tens, hundreds, thousands, or millions of optical system components (along with associated settings and/or other characteristics), and make corrections and/or other adjustments that optimize adjustment and/or processing time, and/or costs. Reinforcement learning is a branch of machine learning where "agents" learn how to operate within a given environment to maximize "rewards". The present systems and methods are configured to train a reinforcement learning framework agent to identify an optimal alignment strategy (the "policy") by interacting with optical system components. Interactions are based on a reward function, which rewards the agent when it makes a "good" move (e.g. improves alignment) and penalizes the agent when it makes a bad move. The present systems and methods are configured to, in the context of optical systems included in lithography apparatuses, metrology apparatuses, etc., minimize a duration of the alignment operation itself, and maximize performance (e.g. throughput), and/or otherwise enhance another alignment metrics. In some embodiments, a joint reward function is used that penalizes alignment move durations and rewards improvement in throughput. As an example, plasma (or Sn droplet) moves are heavily penalized because they are very slow (e.g., microns per second). Conversely, the penalty for a field facet move is much smaller because it is much faster (e.g., about one second per actuation). In this example, the agent of the reinforcement learning framework learns to prioritize field facet moves rather than plasma moves, leading to shorter alignment duration.

In some embodiments, the present systems and methods utilize a simulation of an (e.g., EUV lithography apparatus) optical system. This simulation may include submodules, such as an (EUV) source alone, and/or additional submodules, such as an illuminator and/or projection optics box (POB), and/or other submodules. The agent is trained to interact with this simulation via the reinforcement learning framework described herein.

Although specific reference may be made in this text to the manufacture of ICs, it should be understood that the description herein has many other possible applications. For example, it may be employed in the manufacture of integrated optical systems, guidance and detection patterns for magnetic domain memories, liquid-crystal display panels, thin-film magnetic heads, etc. In these alternative applications, the skilled artisan will appreciate that, in the context of such alternative applications, any use of the terms "reticle", "wafer" or "die" in this text should be considered as interchangeable with the more general terms "mask", "substrate" and "target portion", respectively. In addition, it should be noted that the system(s) and method(s) described herein may have many other possible applications in diverse fields such as language processing systems, self-driving cars, medical imaging and diagnosis, semantic segmentation, denoising, chip design, electronic design automation, etc. The present system(s) and method(s) may be applied in any fields where alignment of optical systems using reinforcement learning is advantageous.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

A patterning device may comprise, or may form, one or more design layouts. The design layout may be generated utilizing CAD (computer-aided design) programs. This process is often referred to as EDA (electronic design automation). Most CAD programs follow a set of predetermined design rules in order to create functional design layouts/patterning devices. These rules are set based processing and design limitations. For example, design rules define the space tolerance between devices (such as gates, capacitors, etc.) or interconnect lines, to ensure that the devices or lines do not interact with one another in an undesirable way. One or more of the design rule limitations may be referred to as a "critical dimension" (CD). A critical dimension of a device can be defined as the smallest width of a line or hole, or the smallest space between two lines or two holes. Thus, the CD regulates the overall size and density of the designed device. One of the goals in device fabrication is to faithfully reproduce the original design intent on the substrate (via the patterning device).

The term "mask" or "patterning device" may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective; binary, phase-shifting, hybrid, etc.), examples of other such patterning devices include a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind. In this manner, the beam becomes patterned according to the addressing pattern of the matrix-addressable surface. The required matrix addressing can be performed using suitable electronic means.

The term "projection optics" may be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

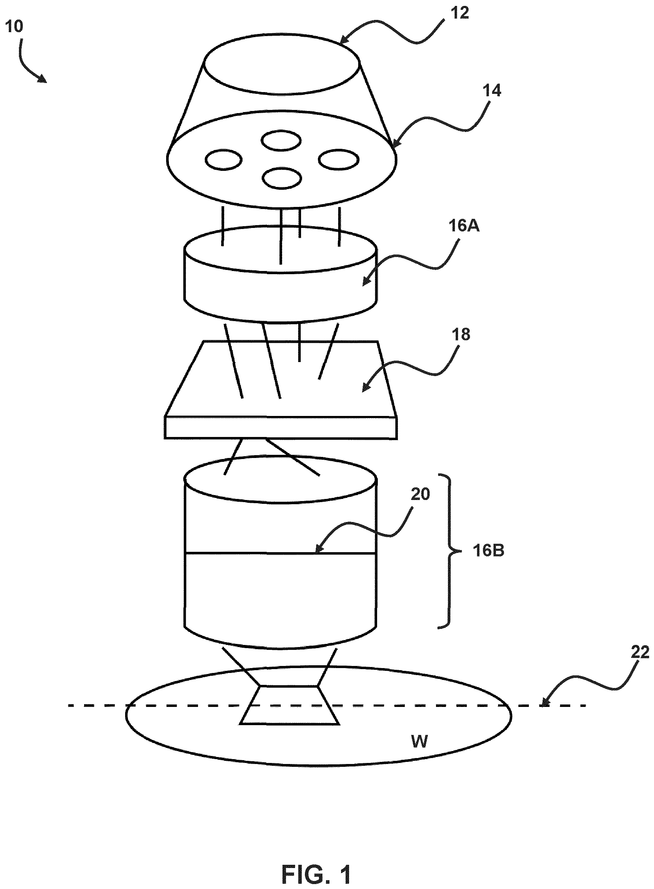

As a brief introduction, Fig. 1 illustrates an exemplary lithographic projection apparatus 10 (e.g., a "lithography apparatus"). Major components are a radiation source 12, which may be a deep-ultraviolet (DUV) excimer laser source or other type of source including an extreme ultra violet (EUV) source, illumination optics which, for example, define the partial coherence (denoted as sigma) and which may include optics 14, 16A that shape radiation from the source 12; a patterning device 18; and transmission optics 16C that project an image of the patterning device pattern onto a substrate W plane 22. An adjustable filter or aperture 20 at the pupil plane of the projection optics may restrict the range of beam angles that impinge on the substrate plane 22, where the largest possible angle defines the numerical aperture of the projection optics NA= n sin(Θₘₐₓ), wherein n is the refractive index of the media between the substrate and the last element of the projection optics, and Θₘₐₓ is the largest angle of the beam exiting from the projection optics that can still impinge on the substrate plane 22. Some and/or all of these components, and/or portions thereof, which include projection optics as described above, may form an optical system and/or submodules of an optical system, for example.

In a lithographic projection apparatus, a source provides illumination (i.e. radiation) to a patterning device and projection optics direct and shape the illumination, via the patterning device, onto a substrate. The projection optics may include at least some of the components 14, 16A, and 16B. An aerial image (AI) is the radiation intensity distribution at substrate level. A resist model can be used to calculate the resist image from the aerial image. The resist model is related to properties of the resist layer (e.g., effects of chemical processes that occur during exposure, post-exposure bake (PEB) and development). Optical properties of the lithographic projection apparatus (e.g., properties of the illumination, the patterning device and the projection optics) dictate the aerial image and can be defined in an optical model. Again here, some and/or all of these components, and/or portions thereof, which include projection optics as described above, may form an optical system and/or submodules of an optical system, for example. In addition, the optical model may be used for some and/or all of the simulation of the optical system and/or submodules of an optical system, as described herein.

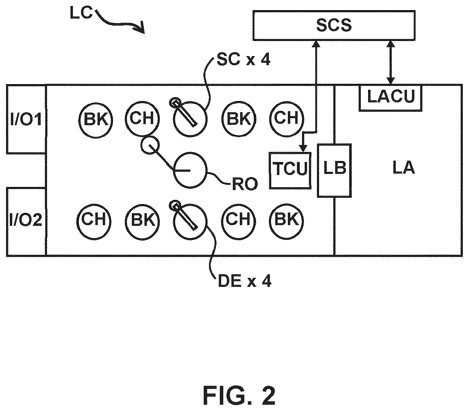

Fig. 2 depicts a schematic overview of a lithographic cell LC. As shown in Fig. 2 the lithographic apparatus LA (which is the same as or similar to lithographic projection apparatus 10 in Fig. 1) may form part of lithographic cell LC, also sometimes referred to as a lithocell or (litho)cluster, which often also includes apparatus to perform pre- and post-exposure processes on a substrate W (Fig. 1). Conventionally, these include spin coaters SC configured to deposit resist layers, developers DE to develop exposed resist, chill plates CH and bake plates BK, e.g. for conditioning the temperature of substrates W for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates, especially if the inspection is done before other substrates of the same batch or lot are still to be exposed or processed.

An inspection apparatus, which may also be referred to as a metrology apparatus, is used to determine properties of the substrates, and how properties of different substrates vary or how properties associated with different layers of the same substrate vary from layer to layer. The inspection apparatus may alternatively be constructed to identify defects on the substrate and may, for example, be part of the lithocell LC, or may be integrated into the lithographic apparatus LA, or may be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or on an etched image (after a pattern transfer step such as etching).

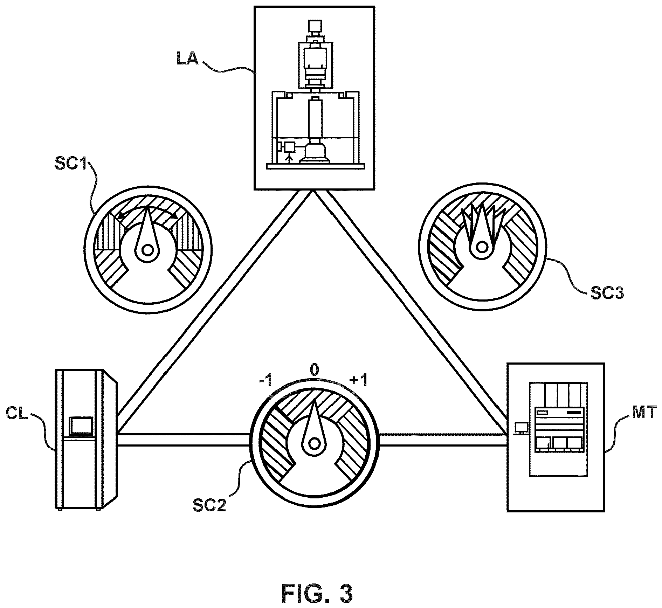

Fig. 3 depicts a schematic representation of holistic lithography, representing a cooperation between three technologies to optimize semiconductor processing. Typically, the patterning process in a lithographic apparatus LA is one of the most critical steps in the processing which requires high accuracy of dimensioning and placement of structures on the substrate. To ensure this high accuracy, three systems (in this example) may be combined in a so called "holistic" control environment as schematically depicted in Fig. 3. One of these systems is the lithographic apparatus LA which is (virtually) connected to a metrology apparatus (e.g., a metrology tool) MT (a second system), and to a computer system CL (a third system). A "holistic" environment may be configured to optimize the cooperation between these three systems to enhance the overall process window and provide tight control loops to ensure that the patterning performed by the lithographic apparatus LA stays within a process window. The process window defines a range of process parameters (e.g. dose, focus, overlay, etc.) within which a specific processing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology apparatus (tool) MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequent measurements of the structures created, e.g., for process control and verification. Tools to make such measurements include metrology tool (apparatus) MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Scatterometers may measure features of a substrate such as gratings using light from soft x-ray and visible to near-IR wavelength range, for example.

In some embodiments, scatterometer MT is adapted to measure the overlay of two misaligned gratings or periodic structures (and/or other target features of a substrate) by measuring asymmetry in the reflected spectrum and/or the detection configuration, the asymmetry being related to the extent of the overlay. Other parameters of interest may be focus and dose. Focus and dose may be determined simultaneously by scatterometry (or alternatively by scanning electron microscopy). A single structure (e.g., a feature in a substrate) may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

It is often desirable to be able computationally determine how a patterning process would produce a desired pattern on a substrate. Computational determination may comprise simulation, for example. Simulations may be provided for one or more parts of the processing process. For example, it is desirable to be able to simulate optical systems, the lithography process of transferring the patterning device pattern onto a resist layer of a substrate, as well as the yielded pattern in that resist layer after development of the resist, simulate metrology operations such as the determination of overlay, and/or perform other simulations. The objective of a simulation may be to accurately predict, for example, metrology metrics (e.g., optical system alignment, overlay, substrate layer alignment, a critical dimension, a reconstruction of a three dimensional profile of features of a substrate, a dose or focus of a lithography apparatus at a moment when the features of the substrate were printed with the lithography apparatus, etc.), processing process parameters (e.g., edge placements, aerial image intensity slopes, sub resolution assist features (SRAF), etc.), and/or other information which can then be used to determine whether an intended or target design has been or will be achieved. The intended design is generally defined as a pre-optical proximity correction design layout which can be provided in a standardized digital file format such as GDSII, OASIS or another file format.

Simulation can be used to determine one or more metrology metrics (e.g., overlay and/or other metrology measurements), configure one or more features of the patterning device pattern (e.g., by simulating optical proximity correction), configure parameters such as alignment for an optical system (e.g., including configuring one or more features of the illumination - by simulating the changing of one or more characteristics of a spatial / angular intensity distribution of the illumination, such as change in a shape, for example; configuring one or more features of the projection optics - numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern together with one or more features of the illumination. The optimizations may use the parameterized model described herein to predict values of various parameters (including images, etc.), for example.

In some embodiments, an optimization process of a system may be represented as a cost function. The optimization process may comprise finding a set of parameters (design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as dose and focus, for example.

In some embodiments, the present system(s) and method(s) may include one or more processors configured to perform one or more of the operations described herein. The one or more processors may comprise one or more algorithms and/or other programming configured to simulate and/or otherwise predict outputs based on correlations between various inputs (e.g., one or more characteristics of one or more components of an optical system, one or more characteristics of an electric field image, one or more characteristics of a design layout, one or more characteristics of the patterning device, one or more characteristics of the illumination used in the lithographic process such as the wavelength, etc.).

As an example, an algorithm may be a machine learning algorithm. In some embodiments, the machine learning algorithm may be and/or include mathematical equations, other algorithms, plots, charts, networks (e.g., neural networks), and/or other tools and machine learning components. For example, the machine learning algorithm may be and/or include one or more neural networks having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be freer flowing, with connections interacting in a more chaotic and complex fashion. In some embodiments, the intermediate layers of the one or more neural networks include one or more convolutional layers, one or more recurrent layers, and/or other layers.

The one or more machine learning algorithms may be trained (i.e., whose parameters are determined) using a set of training data. The training data may include a set of training samples. Each sample may be a pair comprising an input object (typically an image, a measurement, a tensor or vector which may be called a feature tensor or vector) and a desired output value (also called the supervisory signal). A training algorithm analyzes the training data and adjusts the behavior of the algorithm by adjusting the parameters of the algorithm based on the training data. For example, given a set of N training samples of the form {(x₁, y₁), (x₂, y₂), ..., (x_{N}, y_{N})} such that xᵢ is the feature tensor / vector of the i-th example and yᵢ is its supervisory signal, a training algorithm seeks a result g: X → Y, where X is the input space and Y is the output space. A feature tensor / vector is an n-dimensional tensor / vector of numerical features that represent some object (e.g., a complex electric field image). The tensor / vector space associated with these vectors is often called the feature or latent space. After training, the algorithm may be used for making predictions using new samples.

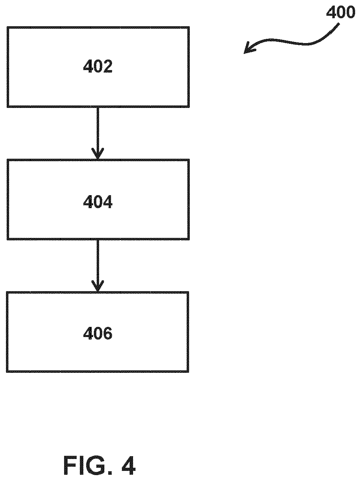

Fig. 4 illustrates a summary of operations of a present method 400 for using reinforcement learning for aligning an optical system (e.g., one or more of the optical systems and/or submodules thereof described herein). Method 400 may be used for aligning tens, hundreds, thousands, or millions of components of an optical system and/or for other purposes. The optical system may comprise an electronic model and/or simulation generated based on a corresponding physical optical system, for example. As described above, corrections and/or other adjustments to an optical system of a lithography, metrology, and/or other apparatuses are typically based on information from a prior manufacturing and/or metrology operation, user experience with the lithography and/or metrology system and/or process, basic optical physics principles, and/or other information.

For example, in a semiconductor processing process, certain parameters, such as overlay (e.g., layer-to-layer alignment offset), Critical Dimension (CD), etc., are measured to ensure the process is proceeding according to (satisfying) processing requirements. These measurements are used to monitor and control the processing process. These measurements, along with additional context data (e.g., which machines and/or other equipment was used, an alignment of the optical systems of such machines, which process parameters were used, which alignment parameters were used, etc.), for one or more prior operations are used in a subsequent optical system alignment to initiate adjustments to the optical system. Advantageously, method 400 uses reinforcement learning to optimize the alignment of tens, hundreds, thousands, or millions of optical system components (along with associated settings and/or other characteristics), and make corrections and/or other adjustments that optimize adjustment and/or processing time, and/or costs.

Adjustments may be based on input information associated with components of an optical system and/or other information. The input information may include relevant historical data for alignment operations, an immediately previous adjustment, the effects from a current adjustment, and/or other information from more than just an immediately previous operation, the machines and/or process equipment used for fabricating and/or measuring those layers, and/or other information. In addition, method 400 is configured to consider the impact adjustments have on processing time, costs associated with processing time and/or overall yield (and/or other process metrics), for example, for a semiconductor device. For example, with method 400, alignment corrections are not applied simply to optimize an alignment value. Instead, alignment corrections are applied with the goal of minimizing the duration of the alignment and/or maximizing performance (e.g. throughput) and/or other process metrics by adapting an entire sequence of corrections and/or other adjustments for an optical system. Method 400 may also reduce costs associated with alignment operations, by determining a sequence of corrections (adjustments) that reduce the duration of an alignment operation, without having to sacrifice throughput, that can be applied across one or more optical systems (e.g., in effect determining a template for future optical alignments). Method 400 may facilitate identification of an optimum set of alignment operations, including which adjustments should be made in which order to which machines, etc., for one or more optical systems. Method 400 (and the associated systems described herein) utilize reinforcement learning to achieve these and other advantages.

In some embodiments, as described herein, method 400 is performed in a simulated optical system and/or semiconductor manufacturing environment (e.g., the "environment" for reinforcement learning as described below). At an operation 402, a state of components of an optical system is determined. Operation 404 comprises determining, based on the state of the components, an alignment metric associated with the components of the optical system. Operation 406 comprises iteratively adjusting the state of the components based on the alignment metric and/or other information. The iterative adjustments are configured to enhance the alignment metric. Determining the state, determining the alignment metric, iteratively adjusting the state, and/or other operations are performed as at least part of a reinforcement learning framework.

The operations of method 400 presented below are intended to be illustrative. In some embodiments, method 400 may be accomplished with one or more additional operations not described, and/or without one or more of the operations discussed. For example, method 400 may include a training operation as described below. Additionally, the order in which the operations of method 400 are illustrated in Fig. 4 and described below is not intended to be limiting.

In some embodiments, one or more portions of method 400 may be implemented (e.g., by simulation) in one or more processing devices (e.g., one or more processors). The one or more processing devices may include one or more devices executing some or all of the operations of method 400 in response to instructions stored electronically on an electronic storage medium. The one or more processing devices may include one or more devices configured through hardware, firmware, and/or software to be specifically designed for execution of one or more of the operations of method 400, for example. In some embodiments, one or more processors form an "agent" of a reinforcement learning framework, for example (as further described below). The agent may be configured such that determining the state (operation 402), determining the alignment metric (operation 404), and/or iteratively adjusting the state (operation 406) are performed for tens, hundreds, thousands, and/or millions of components of the optical system and/or their associated set points, parameters, and/or other contextual information.

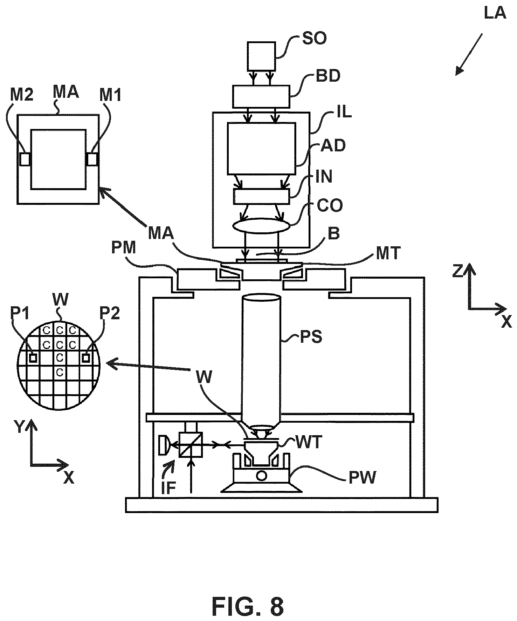

As described above, operation 402 comprises determining a state of components of an optical system. Components of an optical system may include submodules of an optical system, projection optics, a drive laser, a plasma generator, lenses, mirrors, sources, a pupil, etc. (see discussion above related to Fig. 1-3, and discussion below related to Fig. 8-11). The state is determined based on input information associated with the components of the optical system, and/or other information. Input information may comprise measured, modeled, obtained (e.g., electronically and/or manually), inferred and/or other information about the optical system and/or the components of the optical system. In some embodiments, the input information comprises semiconductor manufacturing processing information associated with the optical system and/or other information. In some embodiments the processing information comprises values of measurements of the optical system performed as part of the processing operations, an indication of which alignment operations were previously performed, an indication of an order or of the sequence of prior alignment operations, an indication of which machines, submodules, and/or other equipment was aligned, constants for such machines and/or other equipment, alignment parameters for an optical system, and or other information.

In some embodiments, the optical system comprises an electronic model generated based on a corresponding physical optical system (e.g., as described herein). For example, the optical system may comprise a (simulation of a) source and/or an illuminator, a projection optics box, a drive laser, a plasma generator, lenses, mirrors, sources, a pupil, etc., associated with a lithography apparatus. In some embodiments, the optical system may comprise a (simulation of) corresponding components for a metrology apparatus, and/or other systems.

In some embodiments, the state of the components of the optical system comprises an arrangement of one or more of the optical components relative to each other. In some embodiments, the state of the components of the optical system comprises operating set points and/or other parameters for one or more of the components. In some embodiments, the state of the components of the optical system comprises contextual and/or other information such as an indication of plasma alignment; plasma spatial, angular and/or spectral distributions; plasma energy per pulse per spectral band; drive laser alignment, power, beam profile, temporal profile, and/or pulse profile; mirror physical and/or material properties including spectrally-resolved reflectivity/absorption, surface roughness and stray light behavior, and/or polarization behavior; mirror alignment and/or positioning including a collector position and/or orientation, field facet mirror actuations per field facet, and/or pupil facet mirror alignment; gas absorption behavior including gas species, gas densities, gas pressures, and/or gas temperatures - all spatially and/or spectrally-resolved; relationships and/or behavior associated with mirror degradation rates and effects that can impact mirror degradation rates; and/or other information.

Operation 404 comprises determining, based on the state of the components and/or other information, an alignment metric associated with the components of the optical system. The alignment metric comprises an indication of whether alignment requirements for the components of the optical system are satisfied for the state. In some embodiments, the alignment metric comprises an alignment value. In some embodiments, the alignment metric comprises an optical system alignment speed. In some embodiments, the alignment metric comprises a semiconductor manufacturing process throughput associated with the optical system. In some embodiments, the alignment metric comprises an indication of a tradeoff between alignment speed and process throughput. In some embodiments, the alignment metric comprises a power associated with a semiconductor manufacturing process. In some embodiments, the alignment metric comprises a yield associated with a semiconductor manufacturing process.

In some embodiments, the alignment metric comprises a combination of some and/or all of these metrics. For example, in some embodiments, the alignment metric comprises a combination of throughput associated with a semiconductor device manufacturing process and optical system alignment speed. In this example, enhancing the alignment metric for individual adjusted states during the iteratively adjusting comprises optimizing both the throughput and the alignment speed in combination such that final alignment requirements for the optical system are satisfied.

In some embodiments, the alignment metric is determined based on at least one state within a sequence of states. In some embodiments the alignment metric is determined based on two or more of the states within a sequence of states, a plurality of states within a sequence of states, or all of the states within a sequence states. In some embodiments, the alignment metric is determined based on a sequence of states that includes one or more future states. For example, the alignment metric may be a relative indicator showing that an alignment metric is enhanced or diminished from one state to the next (e.g., after an adjustment as described below). In some embodiments, the alignment metric and/or enhancement of the alignment metric may be the "reward" in the reinforcement learning framework, for example (also as described below).

Operation 406 comprises iteratively adjusting the state of the components. Iterative adjustments are based on the alignment metric and/or other information. In some embodiments, an adjustment comprises a correction. In some embodiments, an adjustment and/or correction comprises a change in an arrangement of the optical components relative to each other, a change in operating set points for one or more of the components, plasma tuning (e.g., laser to droplet offset, drive laser pulse power, drive laser temporal profile, pre-pulse properties and main-pulse properties, etc.) to change the plasma distribution for improved performance metrics and/or for other reasons, environment tuning (e.g., gas properties, thermal effects, cooling flow rates, etc.), plasma position adjustment, field facet and/or other illuminator optics adjustments, orientation adjustments of such components, projection optics box (POB) mirror position adjustments, dose property adjustments (e.g., how much power is generated by the system, and/or how many droplets are hit by the drive laser - to maintain a better controlled and constant output power and/or for other purposes), mirror heating adjustments - in the POB for example - because heating mirrors at specific locations can reduce potential thermomechanical issues / drifts and/or have other effects), and/or other adjustments and/or corrections. The iterative adjustments are configured to enhance the alignment metric and/or have other purposes.

Each adjustment during the iteratively adjusting is determined based on a set of possible actions in an action space associated with the components of the optical system, and a corresponding set of observations that are observed for the components of the optical system in response to an adjustment of the state. The set of possible actions is infinite or finite, and the action space is a continuous or discrete space. For example, in some embodiments, iterative adjustments may generate a sequence of different alignment states for an optical system. A given state may correspond to an alignment of the optical system (e.g., positions of components of an optical system, set points associated with the components, etc.) immediately before or after a specific optical system component is moved, a parameter of the component is changed, and/or other operations. The action or actions that produce a given state can be picked and/or otherwise determined from an infinite number of choices. In some embodiments, an action or actions that produce a given state can be picked and/or otherwise determined from a set and/or otherwise finite number of choices. Adjustments such as changing a set point associated with a component, moving a component from one location to another, etc., are often associated with a continuous set of possible adjustments (e.g., a component can be adjusted from 0.01 units to 0.02 units and all of the sub units in between, not just off or on). Adjustments can also or instead be associated with a discrete set of possible adjustments (e.g., a component can be adjusted from 0.01 units to 0.02 units but not any of the sub units in between, or just off or on). In some embodiments, the sequence of alignment states that result from these different possible actions includes one or more future states of the optical system. These future states may be observed, and observations may be used to adjust and/or change the actions. In some embodiments, determining an adjustment comprises optimizing the alignment metric based on a sequence of states, and determining the adjustment based on the optimized alignment metric.

As a practical example, the action space comprises the set of possible actions that can be taken by the agent (e.g., the one or more processors described herein). In this example, this might refer to possible plasma positions, field facet tilts, etc., associated with an optical system. The observation space generally refers to an observation of the current state, history of the simulation environment, and/or other information. In practice, an observation may comprise any information that is deemed relevant or useful for determining the alignment strategy that maximizes rewards (e.g., as described below). Possible examples of observations in the observation space comprise current EUV power (or throughput or transmission, etc.) gain with respect to previous N alignment steps, where N is a positive integer; a gradient of the EUV power at previous N alignment steps; etc. Another possible example of an observation may be calculated gradient-like values determined using finite differences between consecutive measurements - i.e. by comparing state *i* to state *i*-1 (e.g. (EUV _{power,i} - EUV _{power,i-1})/(xᵢ-xᵢ₋₁)). This is an option if the actual gradient is not available, as is typical in many optical systems. In this example, x can be thought of as a state vector, or the state of the system at step "i". Referring to just the plasma position, for example, then x may be a vector with three elements representing its location in 3D space. Therefore, xᵢ - xᵢ₋₁ gives the change in position in each dimension.

In some embodiments, operation 406 comprises using a determined sequence of adjustments and/or a pattern of adjustments determined based on the iteratively adjusting the state of the components to align one or more corresponding physical optical systems. In some embodiments, iteratively adjusting comprises optimizing the alignment metric based on individual states during a sequence of adjustments, and determining adjustments in the sequence of adjustments based on the optimized alignment metric; prompting a user to make the adjustments, and/or other operations.

In accordance with the reinforcement learning framework, iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied. In some embodiments, determining the alignment metric comprises calculating the alignment metric, and iteratively adjusting the state of the components comprises recalculating the alignment metric for each adjusted state of the components. Some adjustments are rewarded or penalized more than others based on an adjustment speed, semiconductor manufacturing process throughput associated with the optical system, a relative alignment metric enhancement, a relative alignment metric diminishment, an amount of additionally required adjustments to the components of the optical system caused by an adjustment, and/or other factors.

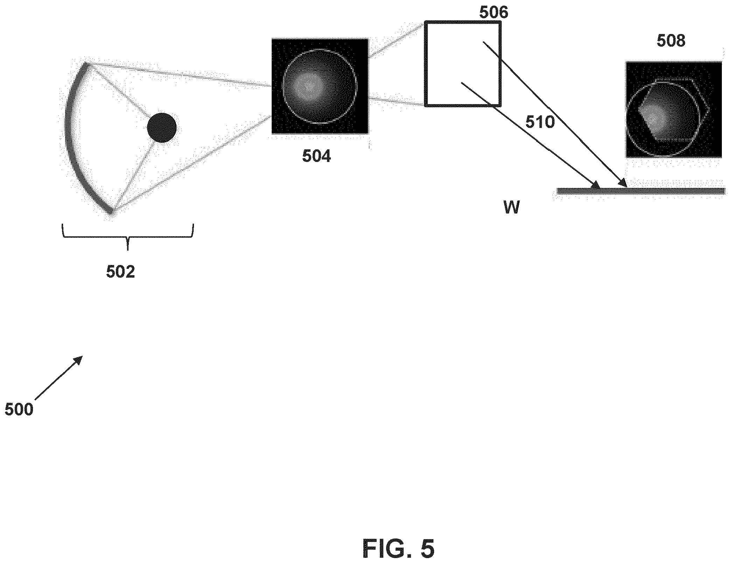

As an example, Fig. 5 illustrates a misaligned optical system 500 that may be aligned using the present systems and methods Optical system 500 includes an EUV plasma generation submodule 502, an intermediate focus submodule 504, field facet mirrors 506, and pupil facet mirrors 508, configured to generate and direct radiation 510 toward a substrate W. With misaligned optical system 500, images at an intermediate focus (associated with intermediate focus submodule 504) and pupil facet mirrors 508 are clipped, leading to throughput losses caused by optical system 500. Reinforcement learning may be used as described herein to better understand the interactions of the source/plasma alignment and/or other components of system 500. Reiterating an example provided above, to determine and/or otherwise improve alignment for system 500, plasma (or Sn droplet) moves associated with EUV plasma generation submodule 502 may be heavily penalized because they are very slow (on the order of microns per second). On the other hand, the penalty for a field facet mirror 506 move may be much smaller because it is much faster (about one second per actuation). In this example, the reinforcement learning framework described herein (e.g., the agent formed by the one or more processors) is configured to learn to prioritize adjustments (e.g., for improving alignment, information gathering, and/or other purposes) via field facet mirror 506 moves rather than plasma generation submodule 502 moves, leading to shorter alignment duration.

In some embodiments, an adjustment may be made automatically by the agent (e.g., one or more processors), by prompting a user to make the adjustment, and/or using other operations. Prompting a user to make the adjustment may include providing a message and or other indication of the adjustment to the user. The message and/or other indication may be provided on a user interface of a computing device associated with the user, a user interface of a computing device associated with a processing operation, and/or other interfaces. In some embodiments, prompting the user to make the adjustment comprises facilitating entry and/or selection of the adjustment by the user through a user interface, and/or other prompting.

Returning to Fig. 4, in some embodiments, iteratively adjusting the state of the components comprises determining a policy function that defines alignment corrections for individual adjusted states; and/or determining a reward function that defines a diminishment and/or an enhancement of the alignment metric assuming the policy function is followed until completion of the iterative adjustments. As described above, determining the state, determining the alignment metric, and iteratively adjusting the state are performed as at least part of a reinforcement learning framework. In some embodiments, the reinforcement learning framework comprises a machine learning algorithm configured for sequential decision-making. In some embodiments, the reinforcement learning framework comprises a trained neural network with weights of the neural network determined based on adjustments that diminish the alignment metric, and adjustments that enhance the alignment metric. Decisions (e.g., adjustments and/or other actions) taken in a given situation (or state) are optimized to maximize a reward (e.g., decreasing the time required for alignment of the optical system, enhancement of the throughput, and/or other alignment metrics). The basic components of the reinforcement learning include a set of states (e.g., as described above), a set of actions (e.g., adjustments as described above), an agent (e.g., one or more processors as described above), an environment (e.g., a simulated optical system and/or semiconductor manufacturing environment), rewards (e.g., for the enhancement of the alignment metric), and penalties (e.g., for the diminishment of the alignment metric).

The actions (adjustments) include corrections and/or other adjustments that may be implemented on an optical system, in associated electronic models, in product design, in metrology target layouts, etc. Note that this may be optical system dependent. The agent is the decision-making entity that determines adjustments and actuates them in the alignment process. The reward, in the alignment process time and/or throughput aware alignment adjustment case, is the enhanced alignment, enhanced throughput and/or decreased alignment process time (and/or the changes in other alignment metrics) accrued at the end of the alignment process.

A negative reward or penalty may be accrued for a given state in which an expensive (e.g., in alignment, time, throughput, or other alignment metrics) adjustment and/or set of adjustments is applied (e.g., some adjustments take longer than others and so are penalized more heavily). This requires a trade-off between optimizing an alignment value (and/or other process metrics) and minimizing adjustments that require a large amount of time, for example.

The environment (e.g., simulated semiconductor processing and/or optical system alignment environment) is made up of all possible states, as well as all transitions between states. Whenever an action (e.g., an adjustment) is taken for a certain state, the optical system moves to a new state, and a reward (and/or penalty) is accrued. The environment (including individual states and transitions between states) may be learned from training data using machine learning (e.g., as described herein), and/or by other methods.

In some embodiments, the determining of the state, the determining of the alignment metric, and the iteratively adjusting the state of the components as part of a serving operational phase. Prior to the serving phase, the policy function and the reward function may be trained during a training operational phase. The training (and/or the serving) operational phase may be performed in the simulated optical system alignment and/or semiconductor manufacturing environment, for example.

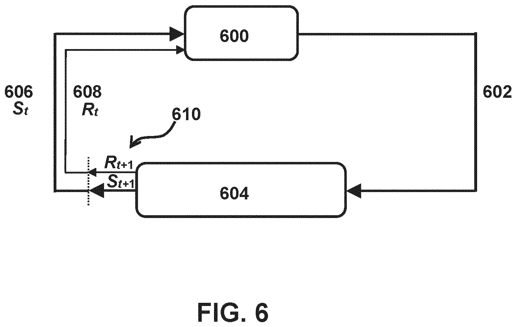

Fig. 6 illustrates how a decision-making agent interacts with the other components of a reinforcement learning framework. As shown in Fig. 6, an agent 600 (e.g., one or more processors) determines a given action (e.g., adjustment) 602 for a given environment (e.g., simulated semiconductor processing and/or optical system alignment environment) 604 based on a current state 606 and a corresponding reward 608 (or conversely a penalty). This process may be iteratively repeated 610 as necessary. Because transitions from state to state are not known (e.g., predetermined) in an optical system alignment context (e.g., an optical system can be aligned using any one of a multitude of different possible alignment operations), the decision making process by agent 600 comprises reinforcement learning.

An optical system may have many possible alignment states, and multiple different possible transitions between states that depend on the actions (e.g., adjustments) taken (made) by the agent (e.g., agent 600 shown in Fig. 6 - which is the one or more processors as described above). A reward (and/or a penalty) is determined for a final alignment state, and/or for each intermediate state. The algorithms that solve reinforcement learning problems are trial-and-error algorithms and/or other algorithms. In some embodiments, the reinforcement learning framework comprises a proximal policy optimization (PPO) algorithm, an asynchronous advantage actor critic algorithm, a Q - learning with normalized advantage function, a trust region policy optimization algorithm, a twin delayed deep deterministic policy gradient, a soft actor - critic algorithm, and/or other algorithms.

The present systems and methods are configured to optimize an alignment metric such as an alignment value, an alignment process time, a throughput, a combination of one or more of these metrics, and/or other alignment metrics described above. As such, adjustments (e.g., corrections, parameter changes, alignment operation order adjustment, etc.) that are made for individual components are determined based on the impact they will have on the alignment metric at the end of the alignment process. In other words, the present systems and methods are not only configured to determine and/or make adjustments for individual states and/or components, but these adjustments follow a policy (e.g., a sequence of adjustments and/or other actions) for a full optical system and/or sequence of states.

The present systems and methods are configured such that individual adjustments incur a reward (e.g., an enhancement of an alignment metric), or a penalty (e.g., negative reward such as worsened alignment, reduced throughput, increased alignment time, etc.). This facilitates consideration of penalties for "expensive" adjustments (e.g., requiring more time, having an effect on multiple other alignment system components that cause those components to need additional adjustments, etc.). This introduces a trade-off between maximizing a process metric such as an alignment value and minimizing (e.g., alignment process time) cost. An output policy (sequence of adjustments) is configured to obtain an enhanced alignment metric (e.g., the best possible alignment) without breaching (e.g., exceeding) a target (e.g., alignment process time) budget.

As described above, in some embodiments, determining the state, determining the alignment metric, and the iterative adjustments are performed as part of a serving operational phase. The serving phase may include using a policy function and a reward function in actual alignment operations and/or other use, for example. Prior to the serving phase, the policy function and the reward function may be generated and/or a machine learning algorithm that generates the value function and/or the reward function may be trained during a training operational phase. In the training phase, the system performs explorative actions and thereby learns the policy function and the reward function using occasional rewards and observations ("exploration"). In some embodiments, the training operational phase is performed in a simulated optical system alignment and/or semiconductor processing environment, and/or with simulated optical system alignment and/or semiconductor processing data. In some embodiments, the training operational phase is performed with actual alignment measurement data. In some embodiments, the training operational phase is performed with both the simulated and actual measurement data, and/or other information. In the serving phase, the learned policy and reward function are used to generate new actions, for example.

Prior to serving an initial policy function and/or reward function for use as described above, an algorithm may be generated and/or trained using training data. The training data comprises alignment states and corresponding performance data, and may be associated with one or more different alignment operations. The alignment states and corresponding performance data may comprise data from actual alignment processes for actual optical systems, and/or optical system alignment process simulations, for example, associated with, related to, and/or representative of, the several optical systems described herein (e.g., see Fig. 1 - Fig. 3 and Fig. 8-11), and/or other data. Training the initial algorithm may comprise providing the training data to the initial algorithm as input to the initial algorithm. The initial algorithm may operate to learn to better predict the performance data based on the corresponding alignment states. Learning to better predict performance may comprise iteratively updating one or more of the algorithm parameters (e.g., before or after serving), and determining whether the update resulted in a better or a worse prediction of the known performance data, for example.

During training of the agent (e.g., the one or more processors), optimization may be split into "episodes." One episode may comprise a sequence of actions that the agent takes to maximize the reward function. In some embodiments, each episode starts with a random state of the optical system and the episode ends after either 1) the agent has taken some fixed number of actions (e.g., max = 50) or 2) the agent has aligned the optical system within some alignment value of a known optimum alignment value. The random starting state of an episode may include random starting alignment positions for different components of the optical system, as well as variation in physical properties of the optical system, and/or variation in other characteristics of the optical system. For example, variation in a collector contamination state may be included at the start of each episode. The agent learns to optimize the alignment of the optical system regardless of the starting contamination state and, in general, this can make a final algorithm more robust to system variations (e.g., plasma, collector, alignment, contamination, temperature, etc.). Training can be performed with any number of available algorithms. For example, a proximal policy optimization (PPO) algorithm and/or other algorithms may be used.

In some embodiments, such as for complex systems like an EUV optical system, training may be computationally intensive, possibly taking days or even weeks to perform. For this reason, distributed computing frameworks (e.g., within a high performance cluster) may be used to speed up training. This can reduce training time significantly.

The trained agent may be used directly on an optical system (e.g., EXE system and/or other systems), and/or its decision-making may be investigated to inform new alignment approaches. Note that a trained agent may be used in many different contexts. For example, an agent could be used to quickly (e.g., in seconds of machine time) determine whether alignment is even required, and may perform additional alignments or corrections, as needed. This may be performed once per day, or more or less often, as needed.

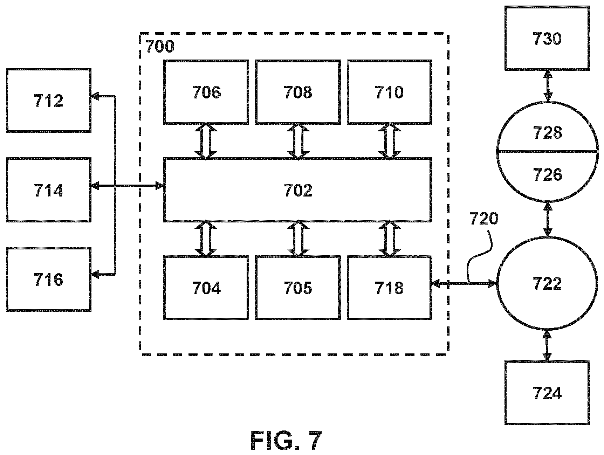

Fig. 7 is a block diagram that illustrates a computer system 00 that can assist in implementing the methods, flows, and/or the systems disclosed herein. Computer system 700 includes a bus 702 or other communication mechanism for communicating information, and a processor 704 (or multiple processors 704 and 705) coupled with bus 702 for processing information. Computer system 700 also includes a main memory 706, such as a random access memory (RAM) or other dynamic storage device, coupled to bus 702 for storing information and instructions to be executed by processor 704. Main memory 706 also may be used for storing temporary variables or other intermediate information during execution of instructions to be executed by processor 704. Computer system 700 further includes a read only memory (ROM) 708 or other static storage device coupled to bus 702 for storing static information and instructions for processor 704. A storage device 710, such as a magnetic disk or optical disk, is provided and coupled to bus 702 for storing information and instructions.

Computer system 700 may be coupled via bus 702 to a display 712, such as a cathode ray tube (CRT) or flat panel or touch panel display for displaying information to a computer user. An input device 714, including alphanumeric and other keys, is coupled to bus 702 for communicating information and command selections to processor 704. Another type of user input device is cursor control 716, such as a mouse, a trackball, or cursor direction keys for communicating direction information and command selections to processor 704 and for controlling cursor movement on display 712. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 700 in response to processor 704 executing one or more sequences of one or more (machine readable) instructions contained in main memory 706. Such instructions may be read into main memory 706 from another computer-readable medium, such as storage device 710. Execution of the sequences of instructions contained in main memory 706 causes processor 704 to perform the process steps described herein. One or more processors in a multi-processing arrangement may also be employed to execute the sequences of instructions contained in main memory 706. In an alternative embodiment, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor 704 for execution. Such a medium may take many forms, including but not limited to, non-volatile media, volatile media, and transmission media. Non-volatile media include, for example, optical or magnetic disks, such as storage device 710. Volatile media include dynamic memory, such as main memory 706. Transmission media include coaxial cables, copper wire and fiber optics, including the wires that comprise bus 702. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 704 for execution. For example, the instructions may initially be borne on a magnetic disk of a remote computer. The remote computer can load the instructions into its dynamic memory and send the instructions over a telephone line using a modem. A modem local to computer system 700 can receive the data on the telephone line and use an infrared transmitter to convert the data to an infrared signal. An infrared detector coupled to bus 702 can receive the data carried in the infrared signal and place the data on bus 702. Bus 702 carries the data to main memory 706, from which processor 704 retrieves and executes the instructions. The instructions received by main memory 706 may optionally be stored on storage device 710 either before or after execution by processor 704.

Computer system 700 may also include a communication interface 718 coupled to bus 702. Communication interface 718 provides a two-way data communication coupling to a network link 720 that is connected to a local network 722. For example, communication interface 718 may be an integrated services digital network (ISDN) card or a modem to provide a data communication connection to a corresponding type of telephone line. As another example, communication interface 718 may be a local area network (LAN) card to provide a data communication connection to a compatible LAN. Wireless links may also be implemented. In any such implementation, communication interface 718 sends and receives electrical, electromagnetic or optical signals that carry digital data streams representing various types of information.

Network link 720 typically provides data communication through one or more networks to other data devices. For example, network link 720 may provide a connection through local network 722 to a host computer 724 or to data equipment operated by an Internet Service Provider (ISP) 726. ISP 726 in turn provides data communication services through the worldwide packet data communication network, now commonly referred to as the "Internet" 728. Local network 722 and Internet 728 both use electrical, electromagnetic or optical signals that carry digital data streams. The signals through the various networks and the signals on network link 720 and through communication interface 718, which carry the digital data to and from computer system 700, are exemplary forms of carrier waves transporting the information.

Computer system 700 can send messages and receive data, including program code, through the network(s), network link 720, and communication interface 718. In the Internet example, a server 730 might transmit a requested code for an application program through Internet 728, ISP 726, local network 722 and communication interface 718. One such downloaded application may provide all or part of a method described herein, for example. The received code may be executed by processor 704 as it is received, and/or stored in storage device 710, or other non-volatile storage for later execution. In this manner, computer system 700 may obtain application code in the form of a carrier wave.

Fig. 8 schematically depicts an exemplary lithographic projection apparatus LA that may be utilized in conjunction with the techniques described herein. Apparatus LA may be similar to and or the same as system 10 shown in Fig. 1, and apparatus LA shown in Fig. 2 and Fig. 3. The apparatus LA comprises an illumination system IL, to condition a beam B of radiation. In this example, the illumination system also comprises a radiation source SO. The apparatus LA comprises a first object table (e.g., patterning device table) MT provided with a patterning device holder to hold a patterning device MA (e.g., a reticle), and connected to a first positioner to accurately position the patterning device with respect to item PS; and a second object table (substrate table) WT provided with a substrate holder to hold a substrate W (e.g., a resist-coated silicon wafer), and connected to a second positioner to accurately position the substrate with respect to item PS. Apparatus LA comprises a projection system ("lens") PS (e.g., a refractive, catoptric or catadioptric optical system) to image an irradiated portion of the patterning device MA onto a target portion C (e.g., comprising one or more dies) of the substrate W. Some or all of these components, or portions of these components may form some or all of an optical system, or a submodule of an optical system, described herein.

In this example, apparatus LA is transmissive (i.e., has a transmissive patterning device). However, in general, it may also be of a reflective type, for example (with a reflective patterning device). The apparatus may employ a different kind of patterning device relative to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, for example. The illuminator IL may comprise adjusting means AD for setting the outer and/or inner radial extent (commonly referred to as σ-outer and σ-inner, respectively) of the intensity distribution in the beam. In addition, it may generally comprise various other components, such as an integrator IN and a condenser CO. In this way, the beam B impinging on the patterning device MA has a desired uniformity and intensity distribution in its cross-section.

In some embodiments, the source SO may be within the housing of the lithographic projection apparatus LA (as is often the case when the source SO is a mercury lamp, for example), or it may also be remote from the lithographic projection apparatus, with the radiation beam that it produces being led into the apparatus (e.g., with the aid of suitable directing mirrors). This latter scenario is often the case when the source SO is an excimer laser (e.g., based on KrF, ArF or F₂ lasing), for example.

The beam B subsequently intercepts the patterning device MA, which is held on a patterning device table MT. Having traversed the patterning device MA, the beam B passes through the projection system PS, which focuses the beam B onto a target portion C of the substrate W. With the aid of the second positioning means (and interferometric measuring means IF), the substrate table WT can be moved accurately, e.g. to position different target portions C in the path of the beam B. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 8. However, in the case of a stepper (as opposed to a step-and-scan tool) the patterning device table MT may just be connected to a short stroke actuator, or may be fixed.

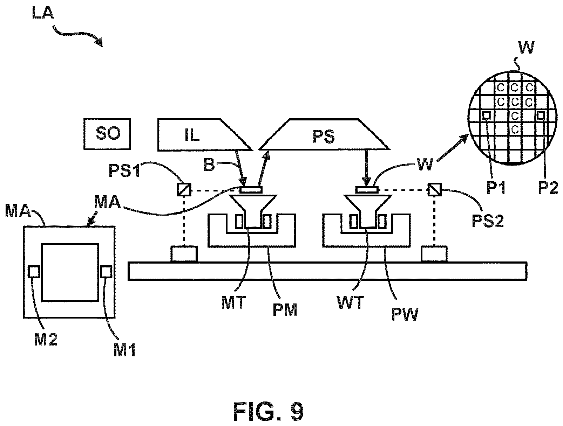

Fig. 9 schematically depicts another exemplary view of lithographic projection apparatus LA that can be utilized in conjunction with the techniques described herein. Lithographic projection apparatus LA comprises source collector module SO, illumination system (illuminator) IL configured to condition a radiation beam B (e.g., EUV radiation), support structure (e.g. a patterning device table) MT constructed to support patterning device (e.g. a mask or a reticle) MA connected to positioner PM configured to accurately position the patterning device; substrate table (e.g. a wafer table) WT configured to hold a substrate (e.g. a resist coated wafer) W and connected to positioner PW configured to accurately position the substrate; and projection system (e.g., a reflective projection system) PS configured to project a pattern imparted to the radiation beam B by patterning device MA onto a target portion C (e.g. comprising one or more dies) of the substrate W. Again here, some or all of these components, or portions of these components may form some or all of an optical system, or a submodule of an optical system, described herein.

In some embodiments, illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 9, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser may not form part of the lithographic apparatus and the radiation beam is passed from the laser to the source collector module with the aid of a beam delivery system comprising, for example, suitable directing mirrors and/or a beam expander. In some embodiments, the source may be an integral part of the source collector module, for example when the source is a discharge produced plasma EUV generator, often termed as a DPP source. In an embodiment, a DUV laser source may be used.

The illuminator IL may comprise adjuster AD (Fig. 8) for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the positioner PW and position sensor PS2 (e.g. an interferometric device, linear encoder or capacitive sensor), the substrate table WT can be moved accurately, e.g. so as to position different target portions C in the path of the radiation beam B. Similarly, the positioner PM and another position sensor PS 1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

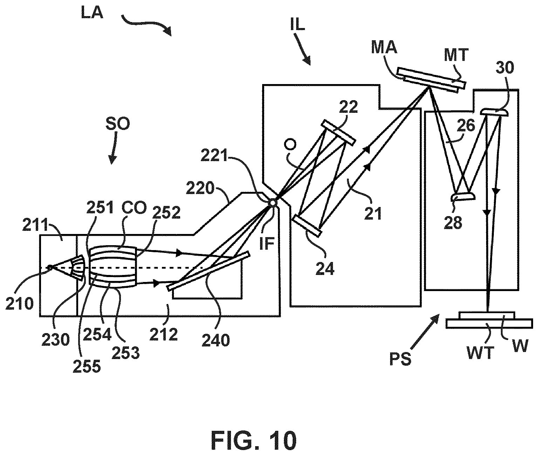

Fig. 10 shows the apparatus LA in more detail, including the source collector module SO, the illumination system IL, and the projection system PS. Again here, some or all of these components, or portions of these components may form some or all of an optical system, or a submodule of an optical system, described herein. The source collector module SO is configured such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the plasma 210 is created to emit radiation in the EUV range of the electromagnetic spectrum. The plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure.

The collector chamber 212 may include a radiation collector CO which may be a grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be any number additional reflective elements present in the projection system PS than shown in Fig. 10.

Collector optic CO, as illustrated in Fig. 10, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

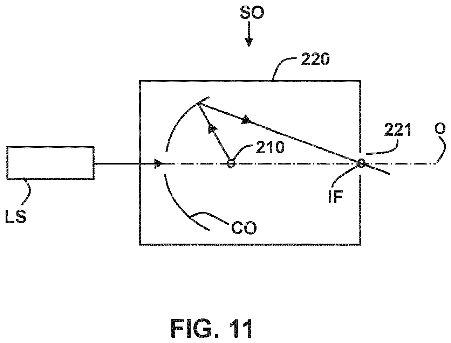

Alternatively, the source collector module SO may be part of an LPP radiation system as shown in Fig. 11. A laser LS is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

Various embodiments of the present systems and methods are disclosed in the subsequent list of numbered clauses:
1. A method for aligning tens, hundreds, thousands, or millions of components of an optical system, the optical system comprising an electronic model generated based on a corresponding physical optical system, the method comprising: determining, with one or more processors, a state of components of the optical system, the state determined based on input information associated with the components of the optical system; determining, with the one or more processors, based on the state of the components, an alignment metric associated with the components of the optical system, the alignment metric comprising an indication of whether alignment requirements for the components of the optical system are satisfied for the state; and iteratively, with the one or more processors, adjusting the state of the components based on the alignment metric, wherein: iterative adjustments are configured to enhance the alignment metric, each adjustment during the iteratively adjusting is determined based on a set of possible actions in an action space associated with the components of the optical system, and a corresponding set of observations that are observed for the components of the optical system in response to an adjustment of the state; the set of possible actions is infinite, and the action space is a continuous or discrete space; wherein determining the state, determining the alignment metric, and iteratively adjusting the state are performed as part of a reinforcement learning framework, the reinforcement learning framework configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
2. The method of clause 1, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
3. The method of any of the previous clauses, wherein the reinforcement learning framework comprises a trained neural network with weights of the neural network determined based on adjustments that diminish the alignment metric, and adjustments that enhance the alignment metric.
4. The method of any of the previous clauses, wherein the one or more processors comprise an agent of the reinforcement learning framework.
5. The method of any of the previous clauses, wherein: iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments; determining the state, determining the alignment metric, and iteratively adjusting the state of the components are performed as part of a serving operational phase; and prior to the serving phase, the policy function and reward function are trained during a training operational phase; and the training operational phase is performed in a simulated semiconductor manufacturing environment.
6. A method for aligning an optical system, the method comprising: determining, with one or more processors, a state of components of the optical system, the state determined based on input information associated with the components of the optical system; determining, with the one or more processors, based on the state of the components, an alignment metric associated with the components of the optical system, the alignment metric comprising an indication of whether alignment requirements for the components of the optical system are satisfied for the state; and iteratively, with the one or more processors, adjusting the state of the components based on the alignment metric, wherein iterative adjustments are configured to enhance the alignment metric; wherein determining the state, determining the alignment metric, and iteratively adjusting the state are performed as at least part of a reinforcement learning framework.
7. The method of any of the previous clauses, wherein iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
8. The method of any of the previous clauses, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
9. The method of any of the previous clauses, wherein determining the state, determining the alignment metric, and iteratively adjusting the state are performed for tens, hundreds, thousands, and/or millions of components of the optical system.
10. The method of any of the previous clauses, wherein the reinforcement learning framework comprises a trained neural network with weights of the neural network determined based on adjustments that diminish the alignment metric, and adjustments that enhance the alignment metric.
11. The method of any of the previous clauses, wherein the one or more processors comprise an agent of the reinforcement learning framework.
12. The method of any of the previous clauses, wherein iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments.
13. The method of any of the previous clauses, further comprising performing the determining of the state, the determining of the alignment metric, and the iteratively adjusting the state of the components as part of a serving operational phase; and prior to the serving phase, training the policy function and the reward function during a training operational phase.
14. The method of any of the previous clauses, wherein the training operational phase is performed in a simulated semiconductor manufacturing environment.
15. The method of any of the previous clauses, wherein determining the alignment metric comprises calculating the alignment metric, and wherein iteratively adjusting the state of the components comprises recalculating the alignment metric for each adjusted state of the components.
16. The method of any of the previous clauses, wherein the optical system comprises an electronic model generated based on a corresponding physical optical system.
17. The method of any of the previous clauses, wherein the optical system comprises a source and/or an illuminator, a projection optics box, a drive laser, and/or a plasma generator associated with a lithography apparatus.
18. The method of any of the previous clauses, wherein the state of the components of the optical system comprises an arrangement of the optical components relative to each other.
19. The method of any of the previous clauses, wherein the state of the components of the optical system comprises operating set points for one or more of the components.
20. The method of any of the previous clauses, wherein the state of the components of the optical system comprises an indication of plasma alignment; plasma spatial, angular and/or spectral distributions; plasma energy per pulse per spectral band; drive laser alignment, power, beam profile, temporal profile, and/or pulse profile; mirror physical and/or material properties including spectrally-resolved reflectivity/absorption, surface roughness and stray light behavior, and/or polarization behavior; mirror alignment and/or positioning including a collector position and/or orientation, field facet mirror actuations per field facet, and/or pupil facet mirror alignment; gas absorption behavior including gas species, gas densities, gas pressures, and/or gas temperatures - all spatially and/or spectrally-resolved; and/or relationships and/or behavior associated with mirror degradation rates and effects that can impact mirror degradation rates.
21. The method of any of the previous clauses, wherein the alignment metric comprises an alignment value.
22. The method of any of the previous clauses, wherein the alignment metric comprises an optical system alignment speed.
23. The method of any of the previous clauses, wherein the alignment metric comprises a semiconductor manufacturing process throughput associated with the optical system.
24. The method of any of the previous clauses, wherein the alignment metric comprises an indication of a tradeoff between alignment speed and process throughput.
25. The method of any of the previous clauses, wherein the alignment metric comprises a power associated with a semiconductor manufacturing process.
26. The method of any of the previous clauses, wherein the alignment metric comprises a yield associated with a semiconductor manufacturing process.
27. The method of any of the previous clauses, further comprising using a sequence of adjustments and/or a pattern of adjustments determined based on the iteratively adjusting the state of the components to align a corresponding physical optical system.
28. The method of any of the previous clauses, wherein the alignment metric comprises a combination of throughput associated with a semiconductor device manufacturing process and optical system alignment speed, and enhancing the alignment metric for individual adjusted states during the iteratively adjusting comprises optimizing both the throughput and the alignment speed in combination such that final alignment requirements for the optical system are satisfied.
29. The method of any of the previous clauses, wherein iteratively adjusting comprises (1) optimizing the alignment metric based on individual states during a sequence of adjustments, and determining adjustments in the sequence of adjustments based on the optimized alignment metric; and/or (2) prompting a user to make the adjustments.
30. The method of any of the previous clauses, wherein an adjustment comprises a correction.
31. The method of any of the previous clauses, wherein an adjustment comprises a change in an arrangement of the optical components relative to each other and/or operating set points for one or more of the components.
32. The method of any of the previous clauses, wherein the input information comprises measured, modeled, and/or inferred information about the optical system and/or the components of the optical system.
33. The method of any of the previous clauses, wherein each adjustment during the iteratively adjusting is determined based on a set of possible actions in an action space associated with the components of the optical system, and a corresponding set of observations that are observed for the components of the optical system in response to an adjustment of the state.
34. The method of any of the previous clauses, wherein the set of possible actions is infinite or finite, and the action space is a continuous or discrete space.
35. The method of any of the previous clauses, wherein the method is performed for a lithography operation in a semiconductor device manufacturing process.
36. A method for training a reinforcement learning framework to align tens, hundreds, thousands, or millions of components of an optical system, the optical system comprising an electronic model generated based on a corresponding physical optical system, the method performed by one or more processors configured by machine readable instructions, the method comprising: inputting input information associated with the components of the optical system into the reinforcement learning framework, and determining a state of the components of the optical system based on the input information; determining, with the reinforcement learning framework, based on the state of the components, an alignment metric associated with the components of the optical system, the alignment metric comprising an indication of whether alignment requirements for the components of the optical system are satisfied for the state; and iteratively, with the reinforcement learning framework, adjusting the state of the components based on the alignment metric, wherein: iterative adjustments are configured to enhance the alignment metric, each adjustment during the iteratively adjusting is determined based on a set of possible actions in an action space associated with the components of the optical system, and a corresponding set of observations that are observed for the components of the optical system in response to an adjustment of the state; the set of possible actions is infinite or finite, and the action space is a continuous or discrete space; wherein, the reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
37. The method of any of the previous clauses, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
38. The method of any of the previous clauses, wherein the reinforcement learning framework comprises a neural network, and training configures weights of the neural network, the weights determined based on adjustments that diminish the alignment metric, and adjustments that enhance the alignment metric.
39. The method of any of the previous clauses, wherein: iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments.
40. The method of any of the previous clauses, wherein the training is performed in a simulated semiconductor manufacturing environment and facilitates identification of an optimum set of alignment operations, including which adjustments should be made in which order for one or more physical optical systems.
41. A non-transitory computer readable medium having instructions thereon, the instructions when executed by a computer causing the computer to perform a method for aligning tens, hundreds, thousands, or millions of components of an optical system, the optical system comprising an electronic model generated based on a corresponding physical optical system, the method comprising: determining, with one or more processors, a state of components of the optical system, the state determined based on input information associated with the components of the optical system; determining, with the one or more processors, based on the state of the components, an alignment metric associated with the components of the optical system, the alignment metric comprising an indication of whether alignment requirements for the components of the optical system are satisfied for the state; and iteratively, with the one or more processors, adjusting the state of the components based on the alignment metric, wherein: iterative adjustments are configured to enhance the alignment metric, each adjustment during the iteratively adjusting is determined based on a set of possible actions in an action space associated with the components of the optical system, and a corresponding set of observations that are observed for the components of the optical system in response to an adjustment of the state; the set of possible actions is infinite, and the action space is a continuous or discrete space; wherein determining the state, determining the alignment metric, and iteratively adjusting the state are performed as part of a reinforcement learning framework, the reinforcement learning framework configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
42. The medium of clause 41, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
43. The medium of any of the previous clauses, wherein the reinforcement learning framework comprises a trained neural network with weights of the neural network determined based on adjustments that diminish the alignment metric, and adjustments that enhance the alignment metric.
44. The medium of any of the previous clauses, wherein the one or more processors comprise an agent of the reinforcement learning framework.
45. The medium of any of the previous clauses, wherein: iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments; determining the state, determining the alignment metric, and iteratively adjusting the state of the components are performed as part of a serving operational phase; and prior to the serving phase, the policy function and reward function are trained during a training operational phase; and the training operational phase is performed in a simulated semiconductor manufacturing environment.
46. A non-transitory computer readable medium having instructions thereon, the instructions when executed by a computer causing the computer to perform a method for aligning an optical system, the method comprising: determining, with one or more processors, a state of components of the optical system, the state determined based on input information associated with the components of the optical system; determining, with the one or more processors, based on the state of the components, an alignment metric associated with the components of the optical system, the alignment metric comprising an indication of whether alignment requirements for the components of the optical system are satisfied for the state; and iteratively, with the one or more processors, adjusting the state of the components based on the alignment metric, wherein iterative adjustments are configured to enhance the alignment metric; wherein determining the state, determining the alignment metric, and iteratively adjusting the state are performed as at least part of a reinforcement learning framework.
47. The medium of any of the previous clauses, wherein iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
48. The medium of any of the previous clauses, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
49. The medium of any of the previous clauses, wherein determining the state, determining the alignment metric, and iteratively adjusting the state are performed for tens, hundreds, thousands, and/or millions of components of the optical system.
50. The medium of any of the previous clauses, wherein the reinforcement learning framework comprises a trained neural network with weights of the neural network determined based on adjustments that diminish the alignment metric, and adjustments that enhance the alignment metric.
51. The medium of any of the previous clauses, wherein the one or more processors comprise an agent of the reinforcement learning framework.
52. The medium of any of the previous clauses, wherein iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments.
53. The medium of any of the previous clauses, the method further comprising performing the determining of the state, the determining of the alignment metric, and the iteratively adjusting the state of the components as part of a serving operational phase; and prior to the serving phase, training the policy function and the reward function during a training operational phase.
54. The medium of any of the previous clauses, wherein the training operational phase is performed in a simulated semiconductor manufacturing environment.
55. The medium of any of the previous clauses, wherein determining the alignment metric comprises calculating the alignment metric, and wherein iteratively adjusting the state of the components comprises recalculating the alignment metric for each adjusted state of the components.
56. The medium of any of the previous clauses, wherein the optical system comprises an electronic model generated based on a corresponding physical optical system.
57. The medium of any of the previous clauses, wherein the optical system comprises a source and/or an illuminator, a projection optics box, a drive laser, and/or a plasma generator associated with a lithography apparatus.
58. The medium of any of the previous clauses, wherein the state of the components of the optical system comprises an arrangement of the optical components relative to each other.
59. The medium of any of any of the previous clauses, wherein the state of the components of the optical system comprises operating set points for one or more of the components.
60. The medium of any of the previous clauses, wherein the state of the components of the optical system comprises an indication of plasma alignment; plasma spatial, angular and/or spectral distributions; plasma energy per pulse per spectral band; drive laser alignment, power, beam profile, temporal profile, and/or pulse profile; mirror physical and/or material properties including spectrally-resolved reflectivity/absorption, surface roughness and stray light behavior, and/or polarization behavior; mirror alignment and/or positioning including a collector position and/or orientation, field facet mirror actuations per field facet, and/or pupil facet mirror alignment; gas absorption behavior including gas species, gas densities, gas pressures, and/or gas temperatures - all spatially and/or spectrally-resolved; and/or relationships and/or behavior associated with mirror degradation rates and effects that can impact mirror degradation rates.
61. The medium of any of the previous clauses, wherein the alignment metric comprises an alignment value.
62. The medium of any of the previous clauses, wherein the alignment metric comprises an optical system alignment speed.
63. The medium of any of the previous clauses, wherein the alignment metric comprises a semiconductor manufacturing process throughput associated with the optical system.
64. The medium of any of the previous clauses, wherein the alignment metric comprises an indication of a tradeoff between alignment speed and process throughput.
65. The medium of any of the previous clauses, wherein the alignment metric comprises a power associated with a semiconductor manufacturing process.
66. The medium of any of the previous clauses, wherein the alignment metric comprises a yield associated with a semiconductor manufacturing process.
67. The medium of any of the previous clauses, the method further comprising using a sequence of adjustments and/or a pattern of adjustments determined based on the iteratively adjusting the state of the components to align a corresponding physical optical system.
68. The medium of any of the previous clauses, wherein the alignment metric comprises a combination of throughput associated with a semiconductor device manufacturing process and optical system alignment speed, and enhancing the alignment metric for individual adjusted states during the iteratively adjusting comprises optimizing both the throughput and the alignment speed in combination such that final alignment requirements for the optical system are satisfied.
69. The medium of any of the previous clauses, wherein iteratively adjusting comprises (1) optimizing the alignment metric based on individual states during a sequence of adjustments, and determining adjustments in the sequence of adjustments based on the optimized alignment metric; and/or (2) prompting a user to make the adjustments.
70. The medium of any of the previous clauses, wherein an adjustment comprises a correction.
71. The medium of any of the previous clauses, wherein an adjustment comprises a change in an arrangement of the optical components relative to each other and/or operating set points for one or more of the components.
72. The medium of any of the previous clauses, wherein the input information comprises measured, modeled, and/or inferred information about the optical system and/or the components of the optical system.
73. The medium of any of the previous clauses, wherein each adjustment during the iteratively adjusting is determined based on a set of possible actions in an action space associated with the components of the optical system, and a corresponding set of observations that are observed for the components of the optical system in response to an adjustment of the state.
74. The medium of any of the previous clauses, wherein the set of possible actions is infinite or finite, and the action space is a continuous or discrete space.
75. The medium of any of the previous clauses, wherein the method is performed for a lithography operation in a semiconductor device manufacturing process.
76. A non-transitory computer readable medium having instructions thereon, the instructions when executed by a computer causing the computer to perform a method for training a reinforcement learning framework to align tens, hundreds, thousands, or millions of components of an optical system, the optical system comprising an electronic model generated based on a corresponding physical optical system, the method performed by one or more processors, the method comprising: inputting input information associated with the components of the optical system into the reinforcement learning framework, and determining a state of the components of the optical system based on the input information; determining, with the reinforcement learning framework, based on the state of the components, an alignment metric associated with the components of the optical system, the alignment metric comprising an indication of whether alignment requirements for the components of the optical system are satisfied for the state; and iteratively, with the reinforcement learning framework, adjusting the state of the components based on the alignment metric, wherein: iterative adjustments are configured to enhance the alignment metric, each adjustment during the iteratively adjusting is determined based on a set of possible actions in an action space associated with the components of the optical system, and a corresponding set of observations that are observed for the components of the optical system in response to an adjustment of the state; the set of possible actions is infinite or finite, and the action space is a continuous or discrete space; wherein, the reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.
77. The medium of any of the previous clauses, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
78. The medium of any of the previous clauses, wherein the reinforcement learning framework comprises a neural network, and training configures weights of the neural network, the weights determined based on adjustments that diminish the alignment metric, and adjustments that enhance the alignment metric.
79. The medium of any of the previous clauses, wherein: iteratively adjusting the state of the components comprises: determining a policy function that defines alignment corrections for individual adjusted states; and/or determining a reward function that defines a diminishment and/or an enhancement of the alignment metric assuming the policy function is followed until completion of the iterative adjustments.
80. The medium of any of the previous clauses, wherein the training is performed in a simulated semiconductor manufacturing environment and facilitates identification of an optimum set of alignment operations, including which adjustments should be made in which order for one or more physical optical systems.
81. A method for aligning components of an optical system, the method comprising: obtaining an alignment template, the alignment template defining an optimum set of alignment operations, including which adjustments should be made to which optical components in which order for the optical system, the alignment template previously determined by: inputting input information associated with the components of the optical system into a reinforcement learning framework; determining, with the reinforcement learning framework, based on a state of the components, an alignment metric associated with the components of the optical system, the alignment metric comprising an indication of whether alignment requirements for the components of the optical system are satisfied for the state; and iteratively, with the reinforcement learning framework, adjusting the state of the components based on the alignment metric, wherein: iterative adjustments are configured to enhance the alignment metric, each adjustment during the iteratively adjusting is determined based on a set of possible actions in an action space associated with the components of the optical system, and a corresponding set of observations that are observed for the components of the optical system in response to an adjustment of the state; and the reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied; and wherein the optimum set of alignment operations, including which adjustments should be made to which optical components in which order for the optical system are determined based on iterative adjustments that satisfy the final alignment requirements for the optical system; and using the alignment template to align the components of the optical system.
82. The method of any of the previous clauses, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.
83. The method of any of the previous clauses, wherein the optical system is a physical optical system, the iteratively adjusting is performed on a simulated version of the physical optical system, and alignment is performed on the physical optical system.
84. The method of any of the previous clauses, wherein the aligning is performed for tens, hundreds, thousands, and/or millions of components of the optical system.
85. The method of any of the previous clauses, wherein the alignment template is determined at a location remote from the optical system.

The concepts disclosed herein may be associated with any generic imaging system for imaging sub wavelength features, any generic metrology system for performing metrology on such features, and may be especially useful with emerging imaging technologies capable of producing increasingly shorter wavelengths. Emerging technologies already in use include EUV (extreme ultra violet) lithography, DUV lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range. The concepts disclosed herein may also simulate or mathematically model these and/or other semiconductor processing steps.

While the concepts disclosed herein may be used for imaging and/or measuring on a substrate such as a silicon wafer, it shall be understood that the disclosed concepts may be used with any type of lithographic imaging systems and/or metrology systems, e.g., those used for imaging and/or metrology on substrates other than silicon wafers. In addition, the combination and sub-combinations of disclosed elements may comprise separate embodiments. For example, a reinforcement learning system and throughput as an alignment metric may be used together in a single embodiment, or the reinforcement learning system may be used separately and/or with another metric. These features may comprise separate embodiments, and/or these features may be used together in the same embodiment.

The descriptions above are intended to be illustrative, not limiting. Thus, it will be apparent to one skilled in the art that modifications may be made as described without departing from the scope of the claims set out below.

## Claims

1. A method for aligning tens, hundreds, thousands, or millions of components of an optical system, the optical system comprising an electronic model generated based on a corresponding physical optical system, the method comprising:
determining, with one or more processors, a state of components of the optical system, the state determined based on input information associated with the components of the optical system;
determining, with the one or more processors, based on the state of the components, an alignment metric associated with the components of the optical system, the alignment metric comprising an indication of whether alignment requirements for the components of the optical system are satisfied for the state; and
iteratively, with the one or more processors, adjusting the state of the components based on the alignment metric, wherein:
iterative adjustments are configured to enhance the alignment metric,
each adjustment during the iteratively adjusting is determined based on a set of possible actions in an action space associated with the components of the optical system, and a corresponding set of observations that are observed for the components of the optical system in response to an adjustment of the state;
the set of possible actions is infinite, and
the action space is a continuous or discrete space;
wherein determining the state, determining the alignment metric, and iteratively adjusting the state are performed as part of a reinforcement learning framework, the reinforcement learning framework configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.

2. The method of claim 1, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.

3. The method of claim 2, wherein the reinforcement learning framework comprises a trained neural network with weights of the neural network determined based on adjustments that diminish the alignment metric, and adjustments that enhance the alignment metric.

4. The method of claim 3, wherein the one or more processors comprise an agent of the reinforcement learning framework.

5. The method of claim 4, wherein:
iteratively adjusting the state of the components comprises:
determining a policy function that defines alignment corrections for individual adjusted states; and/or
determining a reward function that defines a diminishment and/or an enhancement of the alignment metric assuming the policy function is followed until completion of the iterative adjustments;
determining the state, determining the alignment metric, and iteratively adjusting the state of the components are performed as part of a serving operational phase; and prior to the serving phase, the policy function and reward function are trained during a training operational phase; and
the training operational phase is performed in a simulated semiconductor manufacturing environment.

6. A method for training a reinforcement learning framework to align tens, hundreds, thousands, or millions of components of an optical system, the optical system comprising an electronic model generated based on a corresponding physical optical system, the method performed by one or more processors configured by machine readable instructions, the method comprising:
inputting input information associated with the components of the optical system into the reinforcement learning framework, and determining a state of the components of the optical system based on the input information;
determining, with the reinforcement learning framework, based on the state of the components, an alignment metric associated with the components of the optical system, the alignment metric comprising an indication of whether alignment requirements for the components of the optical system are satisfied for the state; and
iteratively, with the reinforcement learning framework, adjusting the state of the components based on the alignment metric, wherein:
iterative adjustments are configured to enhance the alignment metric,
each adjustment during the iteratively adjusting is determined based on a set of possible actions in an action space associated with the components of the optical system, and a corresponding set of observations that are observed for the components of the optical system in response to an adjustment of the state;
the set of possible actions is infinite or finite, and
the action space is a continuous or discrete space;
wherein, the reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied.

7. The method of claim 6, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.

8. The method of claim 7, wherein the reinforcement learning framework comprises a neural network, and training configures weights of the neural network, the weights determined based on adjustments that diminish the alignment metric, and adjustments that enhance the alignment metric.

9. The method of any of claims 6-8, wherein:
iteratively adjusting the state of the components comprises:
determining a policy function that defines alignment corrections for individual adjusted states; and/or
determining a reward function that defines a diminishment and/or an enhancement of the alignment metric assuming the policy function is followed until completion of the iterative adjustments.

10. The method of any of claims 6-9, wherein the training is performed in a simulated semiconductor manufacturing environment and facilitates identification of an optimum set of alignment operations, including which adjustments should be made in which order for one or more physical optical systems.

11. A method for aligning components of an optical system, the method comprising:
obtaining an alignment template, the alignment template defining an optimum set of alignment operations, including which adjustments should be made to which optical components in which order for the optical system, the alignment template previously determined by:
inputting input information associated with the components of the optical system into a reinforcement learning framework;
determining, with the reinforcement learning framework, based on a state of the components, an alignment metric associated with the components of the optical system, the alignment metric comprising an indication of whether alignment requirements for the components of the optical system are satisfied for the state; and
iteratively, with the reinforcement learning framework, adjusting the state of the components based on the alignment metric, wherein:
iterative adjustments are configured to enhance the alignment metric,
each adjustment during the iteratively adjusting is determined based on a set of possible actions in an action space associated with the components of the optical system, and a corresponding set of observations that are observed for the components of the optical system in response to an adjustment of the state; and
the reinforcement learning framework is configured such that iteratively adjusting the state of the components comprises penalizing adjustments that diminish the alignment metric, and rewarding adjustments that enhance the alignment metric, for individual adjusted states during a sequence of adjustments, until final alignment requirements for the optical system are satisfied;
and wherein the optimum set of alignment operations, including which adjustments should be made to which optical components in which order for the optical system are determined based on iterative adjustments that satisfy the final
alignment requirements for the optical system; and
using the alignment template to align the components of the optical system.

12. The method of claim 11, wherein some adjustments are rewarded or penalized more than others based on an adjustment speed, semiconductor manufacturing process throughput associated with the optical system, a relative alignment metric enhancement, a relative alignment metric diminishment, and/or an amount of additionally required adjustments to the components of the optical system caused by an adjustment.

13. The method of claim 11 or 12, wherein the optical system is a physical optical system, the iteratively adjusting is performed on a simulated version of the physical optical system, and alignment is performed on the physical optical system.

14. The method of any of claims 11-13, wherein the aligning is performed for tens, hundreds, thousands, and/or millions of components of the optical system.

15. The method of any of claim 11-14, wherein the alignment template is determined at a location remote from the optical system.
